# EUROPÄISCHE PATENTSCHRIFT

(11) **EP 3 278 119 B1**
(45) Veröffentlichungstag und Bekanntmachung des Hinweises auf die Patenterteilung: **03.07.2019**
(21) Anmeldenummer: 16704627.5
(22) Anmeldetag: 15.02.2016
(51) Int. Cl.: G01R 1/073, G01R 3/00

(54) **ADDITIVES VERFAHREN ZUR HERSTELLUNG EINES KONTAKTABSTANDSWANDLERS SOWIE KONTAKTABSTANDSWANDLER**
ADDITIVE MANUFACTURING METHOD FOR PRODUCING A SPACE TRANSFORMER AND SPACE TRANSFORMER
PROCÉDÉ DE FABRICATION ADDITIVE D'UN CONVERTISSEUR D'ÉCARTEMENT ET CONVERTISSEUR D'ÉCARTEMENT

(30) Priorität: 31.03.2015 DE 102015004150
(43) Veröffentlichungstag der Anmeldung: 07.02.2018
(73) Patentinhaber: Feinmetall GmbH, 71083 Herrenberg (DE)
(72) Erfinder: KÖNIG, Christian, 70794 Filderstadt (DE); BURGOLD, Jörg, 71083 Herrenberg (DE); BÖHM, Gunther, 71154 Nufringen (DE); SCHÄFER, Wolfgang, 72661 Grafenberg (DE)
(74) Vertreter: Clarenbach, Carl-Philipp
(86) Internationale Anmeldenummer: PCT/EP2016/053195
(87) Internationale Veröffentlichungsnummer: WO 2016/155937

(56) Entgegenhaltungen:
- EP-A1- 1 233 272
- EP-A2- 0 802 419
- DE-A1-102015 206 000
- US-A1- 2013 234 748
- US-A1- 2015 137 848
- US-B1- 6 499 216

## Beschreibung

Die Erfindung betrifft ein Verfahren zur Herstellung eines Kontaktabstandswandlers (Spacetransformer), der elektrische Pfade bildende elektrische Kontakte aufweist und bei dem ein erster Kontaktabstand der Kontakte in einen demgegenüber anderen, zweiten Kontaktabstand der elektrische Kontakt gewandelt wird.

Ferner betrifft die Erfindung einen Kontaktabstandswandler.

Es sind verschiedene Verfahren zur Herstellung eines Kontaktabstandswandlers (Spacetransformer) bekannt. Derartige Kontaktabstandswandler dienen innerhalb einer Vorrichtung zur elektrischen Kontaktierung, insbesondere Berührungskontaktierung, für einen elektrischen Prüfling, insbesondere Wafer, dazu, elektrische Pfade zu schaffen, welche sehr kleine Kontaktabstände in größere Kontaktabstände wandeln. Die zu kontaktierenden Kontakte eines elektrischen Prüflings können sehr kleine Mittenabstände aufweisen. Um diese elektrisch berührungskontaktieren zu können, ist der Kontaktabstandswandler erforderlich, der die elektrischen Pfade aufweist, die an einem Ende eine sehr feine Auflösung der Mittenabstände (Rastermaß) der Kontakte aufweist, insbesondere entsprechend der Prüflingskontaktanordnung. Auf seiner anderen Seite weist der Kontaktabstandswandler eine demgegenüber gröbere Auflösung auf, sodass es möglich ist, weitere Bauteile der Vorrichtung elektrisch zu kontaktieren um letztlich einen Kontaktabstand zu erhalten, der den Anschluss einer Prüfeinrichtung ermöglicht. Mittels der Prüfeinrichtung werden elektrische Stromwege geschaltet, die unter Einbeziehung des Kontaktabstandswandlers eine elektrische Prüfung des Prüflings auf dessen elektrische Funktionsfähigkeit gestattet. Die sehr feine Auflösung der elektrischen Pfade kann beispielsweise Mittenabstände der Kontakte zwischen 20 µm und 500 µm aufweisen und die der Prüfeinrichtung (Tester) zugeordnete Seite des Kontaktabstandswandlers kann eine grobe Auflösung im Bereich zwischen 200 µm und 2.600 µm aufweisen. Die bekannten Kontaktabstandstransformer kontaktieren stets einen sogenannten Kontaktkopf, der Federkontakte, zum Beispiel Knickdrähte, aufweist, die der Berührungskontaktierung des Prüflings dienen.

Als bekannter Kontaktabstandswandler ist ein nach dem Verdrahtungsprinzip hergestellter Spacetransformer zu benennen, bei dem elektrische Drähte die Entflechtung (feine Auflösung zu grobe Auflösung) vornehmen. Es sind auch Spacetransformer bekannt, bei denen elektrische Pfade innerhalb einer Platine die Entflechtung durchführen.

Ein Verfahren zum Herstellen eines Kontaktabstandwandlers ist beispielsweise aus der Offenlegungsschrift EP 0 802 419 A2 bekannt. Dieses sieht vor, dass ein Photoresist-Film auf ein Substrat aufgebracht und mittels Photo-Lithographie mit einer Maskenstruktur versehen wird. Anschließend wird ein Kupferfilm aufgebracht, welcher die Photoresist-Struktur als Maske nutzt. Danach wird die Photoresist-Struktur entfernt, wobei auf der Photoresist-Struktur befindliches Kupfer mitentfernt wird und durch verbleibendes Kupfer elektrisch leitende Pfade ausbildet werden.

Die Patentschrift US 6,499,216 B1 beschreibt ein Verfahren zum Herstellen eines Kontaktabstandwandlers, wobei eine elektrisch leitfähige Schicht auf eine Opferschicht durch Galvanisieren aufgebracht wird. Die elektrisch leitfähige Schicht wird zu Leitungen strukturiert, wobei jeweils ein Ende der Leitungen mit einer Trägerschicht verbunden wird. Anschließend werden die Trägerschicht und die Opferschicht derart voneinander entfernt, dass die Leitungen in eine gewünschte Form gebogen werden. Anschließend wird die Opferschicht zur Herstellung des Kontaktabstandswandlers entfernt, sodass Spitzen der Leitungen freigelegt werden.

Die Offenlegungsschrift EP 1 233 272 A1 beschreibt ein Verfahren zum Herstellen eines Kontaktabstandswandlers, wobei ein Grundkörper des Kontaktabstandswandlers schichtweise aufgebaut wird und Prüfstiftkanäle des Grundkörpers zur Ausbildung von elektrischen Kontaktierungen mit einem zunächst fließfähigen elektrisch leitfähigen Material befüllt werden, das anschließend aushärtet.

Bei allen bekannten Lösungen besteht der Nachteil, dass aufgrund der aufwendigen Konstruktionen lange Aufbauzeiten für die Herstellung entstehen und damit sehr hohe Kosten anfallen. Die relativ schnell und flexibel herzustellende Bauform mit Verdrahtung ist wegen ihrer elektrischen Eigenschaften und dem manuell zu erstellenden Aufbau nicht zukunftssicher. Die langen Drahtverbindungen führen beispielsweise zu Übersprechen und der manuelle Aufbau ist nur von besonders geeigneten Mitarbeitern durchführbar, wobei die manuelle Tätigkeit zu einer relativ hohen Fehlerquote führt.

Der Erfindung liegt daher die Aufgabe zugrunde, ein Verfahren zur Herstellung eines Kontaktabstandstransformers (Spacetransformer) anzugeben, dass zu einem einfachen, schnellen und/oder kostengünstigen Aufbau eines derartigen Kontaktabstandswandlers führt, eine optimale Entflechtung mit sich bringt, eine hohe Flexibilität in der Herstellung aufweist, unterschiedliche, kundenspezifische Anforderungen erfüllbar macht und kurze Produktionszeiten erfordert.

Diese Aufgabe wird bei dem eingangs genannten Verfahren durch folgende Schritte mit den Merkmalen des Anspruchs 1 gelöst: Herstellen von jeweils mindestens einem Basisteil von mindestens einigen der elektrischen Kontakte, wobei mindestens ein Teil des Basisteils aus Kunststoff hergestellt wird, und danach erfolgendem Metallisieren von mindestens dem aus Kunststoff hergestellten Teil des Basisteils. Durch die Verwendung von Kunststoff bei der Herstellung des Basisteils lassen sich auf einfache Weise sehr komplexe Strukturen erzeugen, insbesondere auch frei in einem Volumen anordnen, sodass zum Beispiel auch Schrägverläufe dieser Strukturen ermöglicht ist, wodurch eine optimale Entflechtung zu erstellen ist. Um diese Kunststoffstrukturen elektrisch leitfähig zu machen, werden sie nach ihrer Erstellung metallisiert, wodurch die für die elektrische Stromführung erforderlichen elektrisch leitfähigen Pfade gebildet werden. Die sehr feingliedrig herstellbaren Kunststoffstrukturen erlauben eine sehr feine Auflösung der Mittenabstände (insbesondere Rastermaß), wobei aufgrund der insbesondere frei in einem Volumen zu realisierende Pfadführung auf ihrer einen Seite einen ersten Kontaktabstand ermöglichen und auf der anderen Seite einen zweiten Kontaktabstand (insbesondere Mittenabstand), wobei der erste Kontaktabstand gegenüber dem zweiten Kontaktabstand (insbesondere Mittenabstand) entsprechend unterschiedlich groß ist, um die Entflechtung herbeizuführen.

Erfindungsgemäß ist vorgesehen, dass die Herstellung von dem mindestens einen aus Kunststoff bestehenden Teil des Basisteils mittels additivem Fertigungsverfahren erfolgt. Unter additiven Fertigungsverfahren, die auch als "generative Fertigungsverfahren" bezeichnet werden, sind insbesondere schnelle und kostengünstige Fertigungen zu verstehen, die direkt auf der Basis von rechnerinternen Datenmodellen aus formlosen (zum Beispiel Flüssigkeiten, Pulvern oder ähnlichem) oder formneutralen (zum Beispiel bandförmig, drahtförmig und so weiter) Materialien mittels chemischer und/oder physikalischer Prozesse erfolgt. Obwohl es sich dabei um urformende Verfahren handelt, sind für ein konkretes Ergebnis keine speziellen Werkzeuge erforderlich, die die jeweilige Geometrie des Werkstücks gespeichert haben (zum Beispiel Gussformen).

Als additives Fertigungsverfahren wird insbesondere ein selektives Lasersintern von Metallpulver (SLM), ein Stereolithografie-Verfahren (SLA), ein Digital Light Process Rapid Prototyping-Verfahren (DLP) und/oder ein Dip In Laserlithografie-Verfahren (DILL) eingesetzt. Auf die verschiedenen Verfahren wird nachstehend noch näher eingegangen.

Das Metallisieren erfolgt bevorzugt in mindestens einem galvanischen und/oder chemischen Prozess. Ein galvanischer Prozess zeichnet sich dadurch aus, dass elektrischer Strom eingesetzt wird. Der Prozess des chemischen Abscheidens wird auch "außenstromlose Metallabscheidung" genannt. In jedem Falle erfolgt ein Metallaufbau auf der erwähnten Kunststoffgeometrie des Basisteils. Bevorzugt wird eine Metallschicht durch den galvanischen und/oder chemischen Prozess abgeschieden. Hierfür eignen sich insbesonde re Metalle wie Kupfer, Silber, Gold sowie Nickel und auch andere Metalle, die eine elektrische Leitfähigkeit besitzen.

Nach einer Weiterbildung der Erfindung ist vorgesehen, dass das gesamte Basisteil aus Kunststoff, bevorzugt mittels des additiven Fertigungsverfahrens, hergestellt, insbesondere als einstückiges Basisteil hergestellt wird. So wird bevorzugt jeder der elektrischen Pfade aus Kunststoff, insbesondere in einstückiger Form, hergestellt.

Es ist vorgesehen, dass das gesamte Basisteil metallisiert wird. Hierdurch erhält der jeweilige Kunststoffpfad einen metallenen Überzug, der eine elektrische Stromführung beim späteren Einsatz gestattet.

Nach einer Weiterbildung der Erfindung ist vorgesehen, dass vor dem galvanischen Metallisieren eine elektrisch leitfähige Startschicht zumindest auf das aus Kunststoff bestehende Teil des Basisteils aufgebracht oder auf der Oberfläche des Teils erzeugt wird. Sofern ein Kunststoff zum Einsatz gelangt, der elektrisch nicht oder nicht hinreichend leitfähig ist, wird für die galvanische Abscheidung diese elektrisch leitfähige Startschicht benötigt, um einen elektrischen Stromfluss beim Galvanisierungsprozess sicherzustellen. Alternativ kann jedoch auch ein elektrisch leitfähiger Kunststoff oder ein elektrisch leitfähig ausgerüstetes Kunststoff-Komposit für die Erzeugung des Basisteils eingesetzt werden.

Insbesondere ist vorgesehen, dass vor dem insbesondere chemischen Metallisieren eine Keimschicht zumindest auf das aus Kunststoff bestehende Teil des Basisteils aufgebracht wird, insbesondere im Tauch- oder Plasmaverfahren aufgebracht oder auf der Oberfläche des Teils erzeugt wird. Hierdurch werden "Keime" und/oder "Verankerungsstellen" auf der Oberfläche der entsprechenden Kunststoffgeometrie geschaffen, sodass das Metallisieren erfolgen kann.

Bevorzugt ist vorgesehen, dass nach dem Metallisieren das aus Kunststoff bestehende Teil nicht oder zumindest bereichsweise entfernt wird, insbesondere mittels eines Pyrolyseverfahrens, eines nasschemischen Verfahrens und/oder eines trockenchemischen Verfahrens entfernt wird. Selbstverständlich ist es nach dem Metallisieren möglich, den Kunststoffkern, also das Teil des Basisteils oder das gesamte Basisteil, in der Metallhülle verbleiben zu lassen. Alternativ ist es - wie vorstehend erwähnt - möglich, den Kunststoffkern durch ein geeignetes selektives Verfahren aus der Metallhülle zu entfernen. Hierzu bietet sich das erwähnte Pyrolyseverfahren, das nasschemische Verfahren und/oder das trockenchemische Verfahren an. Bevorzugt ist vorgesehen, dass durch das Metallisieren eine metallische Beschichtung oder aufgrund des zumindest bereichsweise erfolgenden Entfernens des aus Kunststoff bestehenden Teils eine hohle Metallhülle erstellt wird. Ferner ist bevorzugt vorgesehen, dass in der durch das Metallisieren gebildeten metallischen Beschichtung/Metallhülle mindestens eine Öffnung erzeugt oder belassen wird, die zum Entweichen von Pyrolyseprodukten dient und/oder einen Zugriff von mindestens einem nass- und/oder trockenchemischen Mittel beim Durchführen des nasschemischen und/oder trockenchemischen Verfahrens ermöglicht. Damit können die entspre chenden Restprodukte entweichen und/oder es ist eine Zugänglichkeit zu dem zu entfernenden Kunststoffmaterial geschaffen.

Nach einer Weiterbildung der Erfindung ist vorgesehen, dass der Kontaktabstandswandler aus mehreren Wandlerzonen zusammengesetzt wird, wobei die elektrischen Kontakte jeweils aus mehreren Kontaktzonen zusammengesetzt werden, jede Kontaktzone einer Wandlerzone angehört und jede Kontaktzone in einer von mehreren, nacheinander durchgeführten Herstellungsstufen erstellt wird, wobei zur Herstellung mindestens einer Kontaktzone von mindestens einer der Wandlerzonen das mindestens eine Basisteil erstellt und anschließend metallisiert wird. Grundsätzlich kann der Kontaktabstandswandler nur eine Wandlerzone aufweisen; vorzugsweise jedoch mehrere Wandlerzonen. Die mehreren Wandlerzonen dienen dazu, die Entflechtung von Wandlerzone zu Wandlerzone zu vergrößern, d.h., jede Wandlerzone besitzt auf einer Seite eine gröbere Auflösung der Mittenabstände der Kontaktzonen als an einer anderen Seite von ihr. Auf diese Art und Weise wird von Wandlerzone zu Wandlerzone die Entflechtung vergrößert. Die Abschnitte der elektrischen Kontakte des Kontaktabstandswandlers in den einzelnen Wandlerzonen werden - wie vorstehend erwähnt - Kontaktzonen genannt, wobei die Summe der aneinandergrenzenden Kontaktzonen eines Kontakts den Gesamtkontakt ergibt. Die Wandlerzonen sind so aufeinander aufgebaut, dass entlang dieses Kontakts, also dieses elektrischen Pfads, eine elektrische Stromführung ermöglicht ist und dass ein benachbarter derartiger elektrischer Pfad von dem erstgenannten elektrischen Pfad elektrisch isoliert ist. Die Erstellung der Wandlerzonen erfolgt im nacheinander durchzuführenden Herstellungsstufen, wobei - gemäß dem Grundgedanken der Erfindung - zur Herstellung mindestens einer Kontaktzone von mindestens einer der Wandlerzonen das mindestens eine Basisteil erstellt und anschließend metallisiert wird. Dies ergibt sich aus dem Verfahren des Anspruchs 1.

Nach einer Weiterbildung der Erfindung ist vorgesehen, dass der Kontaktabstand der Kontakte an einem Ende jeder Kontaktzone gegenüber dem Kontaktabstand der Kontakte an einem anderen Ende dieser Kontaktzone im Abstandsmaß verändert erstellt ist. Im Hinblick auf das Abstandsmaß ist vorgesehen, dass es sich dabei um die erwähnten Mittenabstände handelt, wobei die Kontakte vorzugsweise im gleichmäßigen Raster angeordnet sind, sodass sich das Rastermaß einstellt, das vorstehend bereits erwähnt wurde.

Nach einer Weiterbildung der Erfindung ist vorgesehen, dass bei der Herstellung mindestens einer der Kontaktzonen mindestens eines der additiven Verfahren angewendet wird. Dies entspricht dem Vorgehen, so wie es sich aus dem Anspruch 1 ergibt.

Nach einer Weiterbildung der Erfindung ist vorgesehen, dass bei der Herstellung der aus mehreren Kontaktzonen zusammengesetzten elektrischen Kontakte jede der Kontaktzonen jedes Kontakts mittels eines anderen der additiven Verfahren hergestellt ist. Demzufolge werden die im Anspruch 2 genannten Verfahren zur Erstellung der verschiedenen Kontaktzonen eingesetzt, wobei vorzugsweise jede Kontaktzone eines Kontakts mit einem anderen dieser Verfahren hergestellt ist. Alternativ ist es auch denkbar, dass benachbarte Kontaktzonen mit dem gleichen additiven Verfahren gemäß Anspruch 2 hergestellt werden.

Nach einer Weiterbildung der Erfindung ist vorgesehen, dass in einem Zwischenverfahrensschritt mindestens eine der Wandlerzonen mit einer die betreffenden Kontaktzonen der Kontakte stabilisierenden Stützstruktur hergestellt wird. Dies ist derart zu verstehen, dass die sehr feingliedrigen Kontaktzonen zu ihrer Stabilisierung mittels der Stützstruktur miteinander verbunden sind. Dies erfolgt im noch nicht metallisierten Zustand, d.h., die von der Stützstruktur verbundenen Kontaktzonen bestehen aus Kunststoff. Erst später wird die Metallisierung vorgenommen, wobei zuvor die Stützstruktur derart entfernt wird, dass die Kontaktzonen keine Verbindung mehr untereinander haben, um auf diese Art und Weise Kurzschlüsse zu vermeiden.

Ferner ist vorzugsweise vorgesehen, dass die Stützstruktur mittels additiven Fertigungsverfahren erstellt, insbesondere mit den Kontaktzonen miterstellt wird. In diesem Zusammenhang wird auf die verschiedenen Verfahren des Anspruchs 3 verwiesen. Insbesondere wird bei der Erstellung der Kontaktzonen die Stützstruktur miterstellt, sodass die einzelnen elektrischen Pfade der Kontaktzonen durch die Stützstruktur einen insgesamt hinreichend stabilen Aufbau erhalten, sodass untereinander vorliegende Berührungen von Kontaktzonen vermieden sind, denn diese Berührungen würden später zu einem elektrischen Kurzschluss führen, nämlich sobald die Metallisierung durchgeführt ist und der Einsatz im Prüfverfahren des Prüflings erfolgt. Durch das Miterstellen der Stützstruktur mit den Kontaktzonen ist ein weiterer Verfahrensschritt nicht erforderlich, sondern beide Bauelemente können gemeinsam mit demselben Verfahrensschritt erzeugt werden.

Nach einer Weiterbildung der Erfindung ist vorgesehen, dass die Enden der Kontakte der Kontaktzone mit der Stützstruktur versehen wird, insbesondere mittels dieser untereinander verbunden werden. Es ist also daher nicht erforderlich, die Stützstruktur über die Länge der Kontaktzonen zu erstellen, sondern es reicht aus, nur die Enden der Kontakte mit dieser Stützstruktur zu versehen, wobei die Enden gemeint sind, die die feinere Auflösung und/oder die gröbere Auflösung aufweisen, insbesondere in vorteilhafter Weise die feine Auflösung aufweisen.

Nach einer Weiterbildung der Erfindung ist vorgesehen, dass zumindest eine der Wandlerzonen in aushärtender, elektrisch nicht leitender Vergussmasse eingebettet wird. Die Vergussmasse stabilisiert die Kontaktzonen in dieser Wandlerzone. Durch die elektrisch nicht leitende Eigenschaft der Vergussmasse kommt es nicht zu elektrischen Kurzschlüssen. Selbstverständlich kann die Vergussmasse erst dann zugeführt werden, wenn die Kontaktzonen elektrisch leitfähig sind, also ihre Metallisierung aufweisen.

Eine Weiterbildung der Erfindung sieht vor, dass durch Entfernen eines Teils der Vergussmasse die Enden der Kontaktzonen der betreffenden Kontakte freigelegt werden, gegebenenfalls nach Entfernen der Stützstruktur oder eines Teils von dieser. Die Vergussmasse wird somit im Bereich der Enden der Kontaktzonen entfernt, sodass die Kontaktzonen freigelegt werden und mit Kontaktzonen einer anschließenden Wandlerzone verbunden werden können und/oder einer Kontaktierung, insbesondere Berührungskontaktierung, dienen.

Nach einer Weiterbildung der Erfindung ist vorgesehen, dass nach Entfernen des Teils der Vergussmasse mindestens eine weitere Wandlerzone darauf erstellt wird. Hierauf wurde vorstehend bereits kurz eingegangen.

Die Erfindung betrifft ferner einen Kontaktabstandswandler, hergestellt nach einem der Verfahren, so wie vorstehend angegeben.

Wenn im Zuge dieser Anmeldung von einem Federkontakt und/oder einem Federkontaktstift gesprochen wird, so ist hierunter ein federnder Kontakt zu verstehen, nicht jedoch nur eine ganz konkrete Bauform, beispielsweise diejenige, bei der in einem Mantelrohr ein federbeaufschlagter Kolben verlagerbar ist, der eine aus dem Mantel herausführende Kontaktspitze aufweist oder dergleichen. Es gilt also für die erwähnten beiden Begriffe eine ganz allgemeine Auslegung eines Kontakts der federnd nachgiebig ist und/oder federnd nachgiebig gelagert ist usw.

Die Zeichnungen veranschaulichen die Erfindung anhand von Ausführungsbeispielen und zwar zeigt:
- Figur 1: eine schematische Ansicht einer Vorrichtung zur elektrischen Berührungskontaktierung eines elektrischen Prüflings, insbesondere Wafers, mit einem Kontaktabstandswandler,
- Figur 2: eine schematische Darstellung des Kontaktabstandswandlers,
- Figuren 3 bis 5: schematische Darstellungen einer Wandlerzone des Kontaktabstandswandlers in verschiedenen Herstellungsphasen,
- Figuren 6 und 7: Draufsichten auf einander gegenüberliegende Stirnseiten der Wandlerzone des Kontaktabstandswandlers,
- Figur 8: ein mehrteiliges Blockdiagramm zur Verdeutlichung von Herstellungsstufen eines drei Wandlerzonen aufweisenden Kontaktabstandswandlers und
- Figuren 9 bis 11: verschiedene Federkontakte des Kontaktabstandswandlers zur direkten elektrischen Berührungskontaktierung des Prüflings, insbesondere Wafers.

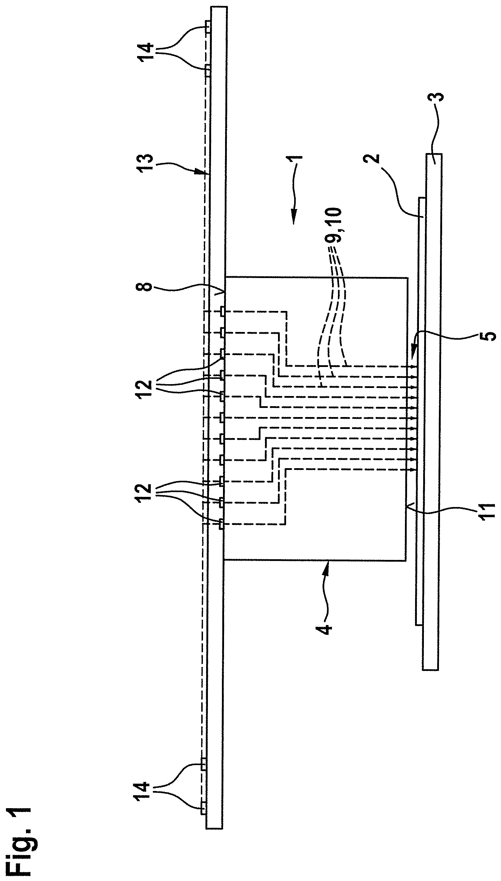

Die Vorrichtung 1 zur elektrischen Berührungskontaktierung für die Prüfung eines elektrischen, sich auf einer Unterlage 3 befindlichen elektrischen Prüflings 2, insbesondere Wafers, weist gemäß Figur 1 einen Kontaktabstandswandler 4 (Spacetransformer) und eine Leiterplatte 13 auf. Der Kontaktabstandswandler 4 weist hervorstehende Federkontaktstift 5 auf, die bei der Prüfung des Prüflings 2 auf dessen Prüflingskontakte 6 aufgesetzt werden. Die Federkontaktstifte 5, die eine Ebene aufspannenden und rasterartig angeordnet sind, weisen zueinander einen Kontaktabstand 7 auf, der sehr klein ist. Dies bedeutet, dass eine sehr feine Auflösung vorliegt, die mittels des Kontaktabstandswandlers 4 in eine gröbere Auflösung gewandelt wird. Die gröbere Auflösung liegt an der dem Prüfling 2 abgewandten Seite 8 des Kontaktabstandswandlers 4 vor. Beispielsweise können die Mittenabstände der Prüflingskontakte 20 µm betragen und die Mittenabstände auf der Seite 8 betragen beispielsweise 600 µm. Um diese "Entflechtung" vorzunehmen, weist der Kontaktabstandswandler 4 elektrische Kontakte 9 auf, die elektrische Pfade 10 bilden und sich von einer dem Prüfling 2 zugewandten Seite 11 des Kontaktabstandswandlers 4 bis zu der Seite 8 erstrecken, die prüflingsabgewandt liegt. Die elektrischen Pfade 10 stehen einerseits mit den Federkontaktstiften 5 in elektrischer Verbindung und sind andererseits mit Kontaktflächen 12 der Leiterplatte 13 verbunden, die der Seite 8 des Kontaktabstandswandlers 4 zugeordnet ist. Innerhalb und/oder bevorzugt auf der Leiterplatte 13 verlaufen - ausgehend von den Kontaktflächen 12 - elektrische Leiterbahnen bis zu peripher auf der Leiterplatte 13 angeordnete Kontaktflächen 14, wodurch eine weitere Entflechtung der Kontaktabstände stattfindet. Die Kontaktflächen 14 sind über elektrische Kabel mit einer nicht dargestellten Prüfeinrichtung (Tester) verbunden, mit der elektrische Stromwege geschaltet werden können, um den elektrischen Prüfling 2 einer Prüfung auf Funktionsfähigkeit zu unterziehen.

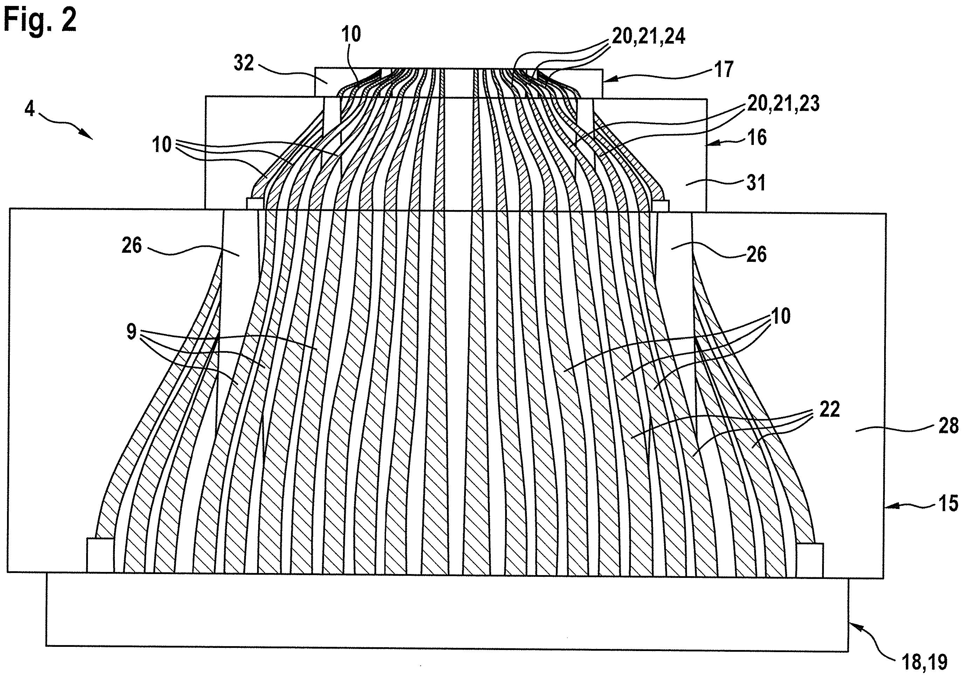

Der in der Figur 1 nur schematisch dargestellte Kontaktabstandswandler 4 wird anhand der Figur 2 nunmehr näher erläutert, wobei er in der Figur 2 konkreter, dennoch weitestgehend schematisch dargestellt ist. Ferner ist zur Figur 2 anzumerken, dass der dort abgebildete Kontaktabstandswandler 4 noch nicht fertiggestellt ist, d.h., es wird eine Herstellungszwischenstufe gezeigt.

Der in der Figur 2 dargestellte Kontaktabstandswandler 4 setzt sich aus mehreren, nämlich im dargestellten Ausführungsbeispiel aus drei Wandlerzonen 15, 16 und 17 zusammen, wobei hinsichtlich der Kontaktabstände jede Wandlerzone 15, 16, 17 eine Entflechtung vornimmt, wobei die Entflechtung einer Wandlerzone, zum Beispiel 15, von der folgenden Wandlerzone, nämlich der Wandlerzone 16 aufgenommen und weitergeführt, nämlich der Wandlerzone 17 übergeben wird, die ebenfalls ihre Entflechtung durchführt, sodass insgesamt - über die drei Wandlerzonen 15 bis 17 gesehen - eine sehr wirksame Entflechtung erfolgt, dass also die sehr feine Auflösung der elektrischen Pfade 10 bis in eine recht grobe Auflösung überführt wird oder umgekehrt. Grundsätzlich kann der erfindungsgemäße Kontaktabstandswandler 4 auch nur aus einer Wandlerzone bestehen oder es sind mehrere Wandlerzonen vorhanden, wobei im Ausführungsbeispiel der Figur 2 drei Wandlerzonen gezeigt sind. Auch Ausführungsbeispiele mit zwei Wandlerzonen oder mehr als drei Wandlerzonen können realisiert werden. Im nachstehenden wird der Reihe nach auf die Herstellung der Wandlerzone 15, dann auf die Wandlerzone 16 und dann auf die Wandlerzone 17 eingegangen, also von der groben Auflösung hin zur feinen Auflösung. In dieser Reihenfolge erfolgt die Herstellung des mehrzonigen Kontaktabstandswandlers 4.

Zur Herstellung der Wandlerzone 15 wird mittels eines additiven Fertigungsverfahrens zunächst auf einer Grundstruktur 18, die als Grundplatte 19 ausgebildet sein kann, ein Abschnitt der die elektrischen Pfade 10 bildenden Kontakte 9 erstellt. Grundsätzlich ist es möglich, auch die Grundstruktur 18 mittels des additiven Fertigungsverfahrens zu erstellen. Alternativ kann jedoch auch vorgesehen sein, dass die Grundstruktur 18 auf andere Art und Weise hergestellt und dann als Träger für den dort erfolgenden Aufbau der Kontakte 9 genutzt wird. Da es sich bei der Wandlerzone 15 um elektrische Pfade 10 in relativ grober Auflösung handelt, wird ein geeignetes additives Fertigungsverfahren gewählt. Nach einer Option wird mit Hilfe dieses additiven Fertigungsverfahrens bei jedem Pfad 10 zunächst ein Basisteil 20 aus Kunststoff hergestellt. Dieses Basisteil 20 wird anschließend metallisiert, also mit einer metallischen Beschichtung 21 versehen. In entsprechender Weise werden die Bereiche der Kontakte 9 in den Wandlerzonen 16 und 17 hergestellt. Beim konkreten Ausführungsbeispiel der Figur 2 wird im Hinblick auf die Wandlerzone 15 jedoch alternativ zum Vorstehenden nach einer weiteren Option vorgegangen, nämlich die Erstellung der entsprechenden Bereiche der Kontakte 9 mittels selektivem Lasersintern von Metallpulver (SLM). Hierbei handelt es sich ebenfalls um ein additives Fertigungsverfahren. Da durch das Sintern des Metallpulvers jeweils ein elektrischer Pfad 10 entsteht, der aufgrund des Metalls elektrisch leitfähig ist, kann auf eine metallische Beschichtung verzichtet werden. Bei dem selektiven Lasersintern des Metallpulvers wird jeweils eine Schicht des Metallpulvers selektiv verschmolzen (gesintert). Auf diese Art und Weise werden aus vielen übereinandergeschichteten Lagen die Abschnitte der elektrischen Kontakte 9 erstellt. Diese Abschnitte werden nachstehend als Kontaktzonen 22 der Kontakte 9 bezeichnet. Auch die Wandlerzone 16 weist entsprechende Kontaktzonen auf, die mit 23 bezeichnet sind und entsprechendes gilt für die Wandlerzone 15, bei der die Bereiche der Kontakte 9 als Kontaktzonen 24 bezeichnet werden. Die aneinander angrenzenden und elektrisch miteinander verbundenen Kontaktzonen 22 bis 24 bilden also insgesamt die elektrischen Kontakte 9 und dementsprechend die elektrischen Pfade 10 aus.

Bei dem genannten selektiven Lasersintern von Metallpulver zur Erstellung der Kontaktzonen 22 muss nach jedem Sinterschritt eine neue Lage Metallpulver beispielsweise mittels eines Rakels aufgebracht werden, die dann mittels des Lasers verschmolzen wird. Als Metallpulverwerkstoff sind neben Edelstählen insbesondere auch Wolfram, Molybdän oder Silberlegierungen einsetzbar. Wolfram, Molybdän und/oder Silberlegierungen eigenen sich aufgrund ihrer guten elektrischen Eigenschaften besonders für die Erfindung. Das verwendete selektive Sinterverfahren ist zur Erzeugung der groben Auflösung deshalb besonders gut geeignet, weil metallischer Werkstoff zum Einsatz gelangt, also eine elektrische Leitfähigkeit von Grund auf gegeben ist und es lassen sich relativ große Volumina herstellen. Da bei der Wandlerzone 15 die relativ geringe Auflösung vorliegt, eignet sich dieses Verfahren, da sehr feine Auflösungen nicht prozesssicher hergestellt werden können. Aufgrund des erwähnten Rakelprozesses lassen sich gegenüber der Ebene der Grundplatte 19 schräg verlaufende Strukturen realisieren, deren Schrägverlauf (Winkel) größer als 45° gegenüber dieser Ebene verlaufen. Wie aus der Figur 2 ersichtlich ist, lassen sich demzufolge die geschwungenen Verläufe der einzelnen Kontaktzonen 22 problemlos realisieren.

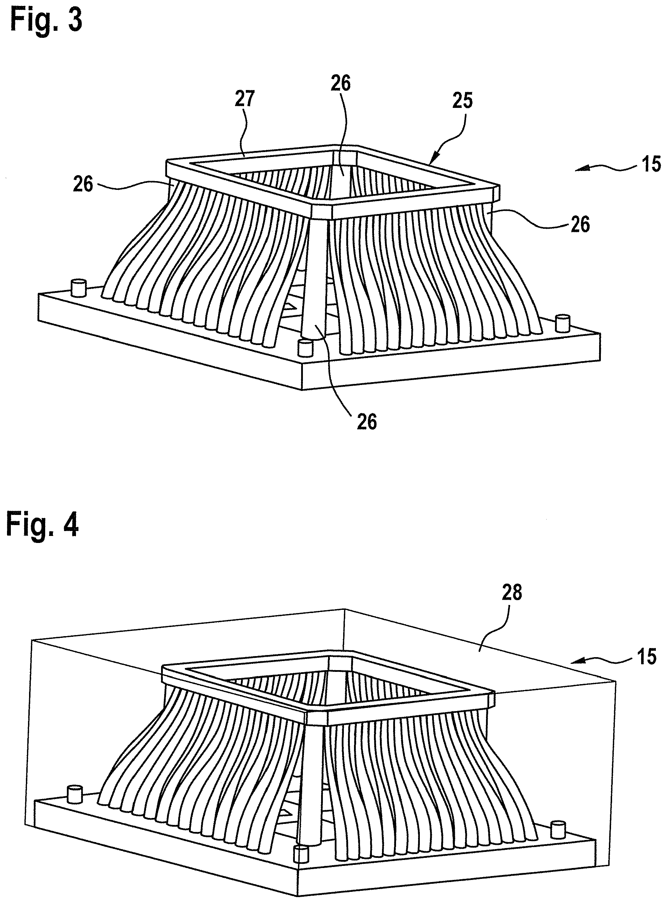

Die Figuren 3 bis 5 verdeutlichen im Detail die Erstellung der Wandlerzone 15, d.h., es werden weitergehende Herstellungsschritte anhand dieser Figuren erläutert, die aus der Figur 2 nicht hervorgehen. Die Figur 3 zeigt, dass zusätzlich zu den Kontaktzonen 22 auf der Grundstruktur 18 eine Stützstruktur 25 hergestellt wird. Diese Stützstruktur 25 wird ebenfalls im additiven Fertigungsverfahren erzeugt, nämlich gleichfalls durch selektives Lasersintern von Metallpulver (SLM), mit anderen Worten: Es werden sowohl die Kontaktzonen 22 als auch die Stützstruktur 25 gleichzeitig hergestellt. Die Stützstruktur 25 weist gemäß Figur 3 mehrere Stützsäulen 26 auf, die an ihren Enden mittels einer Ringstruktur 27, die ebenfalls der Stützstruktur 25 angehört, verbunden sind. Ferner sind auch die von der Grundstruktur 18 entfernt liegenden Enden der Kontaktzonen 22 mit der Ringstruktur 27 derart verbunden, dass die einzelnen Kontaktzonen 22 mit Abstand zueinander liegen. Die Stützstruktur 25 stabilisiert demzufolge den mechanischen Aufbau der Kontaktzonen 22. Natürlich kann die Stützstruktur 25 auch eine gegenüber der Darstellung der Figur 3 andersartige Gestalt aufweisen. Wichtig ist nur, dass die mechanische Versteifung erfolgt und die Abstandshaltung der einzelnen Abschnitte der Kontakte 9 gewahrt ist, um später elektrische Kurzschlüsse bei dem Einsatz des Kontaktabstandswandlers 4 zu vermeiden.

In einem Folgeverfahrensschritt wird die aus der Figur 3 hervorgehende Struktur in eine aushärtende Vergussmasse 28 gemäß Figur 4 eingebettet. Diese Vergussmasse 28 ist elektrisch nicht leitfähig. Vorzugsweise kann als Vergussmasse 28 Kunstharz eingesetzt werden. Um gute thermische Eigenschaften zu erhalten verwendet man vorzugsweise mit Keramikpartikeln gefüllt Harze, insbesondere Kunstharze. Die für die genannte elektrische Entflechtung relevanten, feinen, faserartigen elektrischen Pfade 10 werden somit einerseits durch die Stützstruktur 25 und andererseits auch durch das Eingießen in aushärtende Vergussmasse 28 gehalten, sodass sie in Nachfolgeprozessen nicht verbogen oder beschädigt werden. Die Ausbildung einer vorzugsweise rahmenartigen Geometrie der Stützstruktur 25 erfolgt immer an dem Ende der Kontaktzonen, die ein feineres Raster gegenüber ihren anderen Enden (gröberes Raster) aufweisen. Bei dem erwähnten, kompletten Eingießen der Wandlerzone 15 sind Lufteinschlüsse zu vermeiden, d.h., es wird ein lufteinschlussfreies Vergießen vorgenommen.

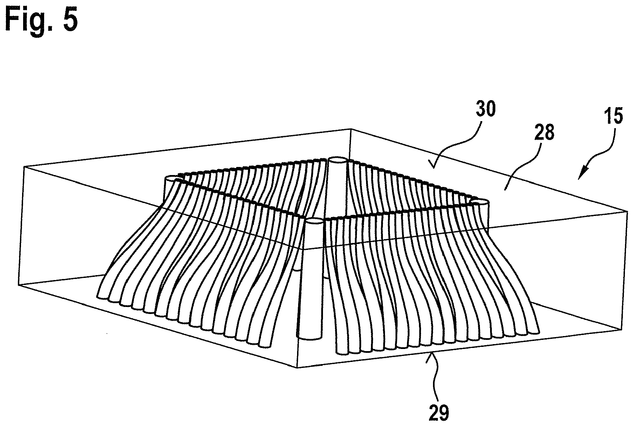

In einem nachfolgenden Herstellungsschritt wird nunmehr gemäß Figur 5 nach dem Aushärten der Vergussmasse 28 der rahmenartige Bereich der Stützstruktur 25, also die Ringstruktur 27, und auch die ebenfalls als Stütze und dem Aufbau dienende Grundstruktur 18 entfernt. Vorzugsweise werden zwei parallele Stirnflächen 29 und 30 der Vergussmasse 28 geschaffen. Dies kann durch Fräs- und/oder Schleifprozesse erfolgen. Nunmehr ist die Wandlerzone 15 fertig erstellt, sodass auf dieser die Wandlerzone 16 aufgebaut werden kann. Der Aufbau der Wandlerzone 16 erfolgt direkt auf der Wandlerzone 15. Hierdurch ist unter anderem sichergestellt, dass sich die Kontaktzonen 23 der zu erstellenden Wandlerzone 16 mit den Kontaktzonen 22 der Wandlerzone 15 elektrisch verbinden, sodass eine elektrische Stromführung der einzelnen Pfade 10 gesichert ist.

Wie bereits angedeutet, erfolgt die Herstellung der Kontaktzonen 23 der Wandlerzone 16 durch Erstellung von Basisteilen 20 aus Kunststoff, die anschließend mit einer metallischen Beschichtung 21 versehen werden. Im Einzelnen wird hierzu als additives Fertigungsverfahren ein Stereolithografie-Verfahren (SLA) oder ein Digital Light Process Rapid Prototyping-Verfahren (DLP) verwandt, um die Basisteile 20 aus Kunststoff zu erstellen. Bei den beiden genannten additiven Verfahren (SLA beziehungsweise DLP) kommt jeweils ein fotoaktiver flüssiger oder pastöser Kunststoff, zum Beispiel Acryllack, zum Einsatz, der mit Hilfe von Strahlung, zum Beispiel Laserstrahlung, schichtweise vernetzt wird. Die herzustellenden Kontaktzonen 23 werden Schicht für Schicht aufgebaut, wobei diese Technologie den Aufbau einer feineren Struktur gegenüber dem zuvor genannten SLM-Prozess zulässt. Es können auch sehr kleine Winkel (< 5°) bezüglich einer X-Y-Ebene realisiert werden, d.h., es lassen sich entsprechende Schrägverläufe der Kontaktzonen 23 realisieren, um die Entflechtung vorzunehmen. Der schichtweise Aufbau der elektrischen Pfade 10 erfolgt demzufolge durch Vernetzen des Kunststoffs, wobei vorzugsweise wiederum eine am Ende dieser Pfade 10 der Wandlerzone 16 angreifende Stützstruktur (nicht gezeigt) aufgebaut/mitaufgebaut wird, um eine mechanische Abstützung zu gewährleisten. Um jedoch nun die elektrische Leitfähigkeit der so erzeugten Kunststoffstrukturen zu erhalten, ist ein weiterer Prozessschritt, nämlich das erwähnte Metallisieren der Kontaktzonen 23 notwendig. Hierbei wird die komplette Wandlerzone 16 einschließlich der eventuell vorliegenden Stützstruktur mit einer elektrisch leitfähigen Beschichtung 21 versehen. Wie das im Einzelnen erfolgt, wird nachstehend noch ausgeführt. Bei der Erzeugung der Beschichtung 21 ist darauf zu achten, dass keine Verbindung zwischen den einzelnen Kontaktzonen 23 vorliegt, die später zu einem elektrischen Kurschluss führen könnte. Ist die Metallisierung durchgeführt, so wird - wie vorstehend bereits zur Wandlerzone 15 beschrieben - ein Verguss mit aushärtender Vergussmasse 31 durchgeführt und anschließend ein Teil der Vergussmasse und der gegebenenfalls vorgesehenen Stützstruktur entfernt.

Nunmehr erfolgt die Herstellung der Wandlerzone 17, und zwar direkt auf der Wandlerzone 16. Bevorzugt wird hierzu ein DILL-Verfahren eingesetzt, also ein Dip In Laserlithografie-Verfahren, das die Realisierung besonders feiner Strukturen, also eine sehr hohe Auflösung ermöglicht. Bei dem Dip In Laserlithografie-Verfahren (DILL), das auch als Zwei-Photonen-Lithografie bezeichnet wird, und ebenfalls ein additives Fertigungsverfahren ist, taucht ein Objektiv eines Lasers direkt in den zu verarbeitenden Werkstoff, zum Beispiel Acryllack ein, wodurch der Vorteil besteht, dass es zu keinen Störungen an Grenzflächen zwischen den unterschiedlichen Medien kommt. Vorzugsweise taucht das Objektiv von unten in den "hängenden" Werkstoff ein. Hierdurch werden nun wiederum die aus Kunststoff bestehenden Basisteile 20 der Kontaktzonen 24 der Wandlerzone 17 erzeugt. Dabei ist es optional möglich, wiederum eine Stützstruktur (nicht gezeigt) mit zu erzeugen. Mit dem Dip In Laserlithografie-Verfahren lassen sich nur kleine Werkstoffvolumina verarbeiten, was jedoch aufgrund der hohen Auflösung der elektrischen Pfade 10 in diesem Bereich kein Problem darstellt. Anschließend werden die so erzeugten Basisteile 20 metallisiert, also mit einer metallischen Beschichtung 21 versehen. Nach Vergießen mit Vergussmasse 32 und Entfernen von Bereichen der ausgehärteten Vergussmasse 32 und gegebenenfalls von Teilen der Stützstruktur, ist der Kontaktabstandswandler 4 fertiggestellt.

Die Kontaktzonen 22, 23 und 24 sind zur Ausbildung der kompletten elektrischen Pfade 10 beziehungsweise elektrischen Kontakte 9 in Reihe zueinander geschaltet, wobei in jeder Wandlerzone 15, 16 und 17 durch entsprechende Schrägführung der elektrischen Pfade 10 eine Entflechtung erfolgt, sodass insgesamt von einer sehr feinen Auflösung der Kontaktabstände der Wandlerzone 17 auf eine grobe Auflösung der Kontaktabstände der Wandlerzone 15 übergegangen wird. Diese Ausgestaltung ist der Figur 2 deutlich zu entnehmen, wobei dort noch die Grundstruktur 18 beziehungsweise Grundplatte 19 ersichtlich ist, die zu entfernen ist. Beim Ausführungsbeispiel der Figur 2 wird demzufolge die Grundstruktur 18 nicht vor dem Erstellen der Wandlerzone 16 entfernt, sondern erst zu einem späteren Zeitpunkt.

Nunmehr soll auf die Metallisierung näher eingegangen werden. Auf die aus Kunststoff bestehenden Basisteile 20 der Kontaktzonen 23 und 24 ist die metallische Beschichtung 21 aufzubringen. Sofern die Wandlerzone 15 auch Basisteile 20 aus Kunststoff aufweist, ist auch hier die Aufbringung der metallischen Beschichtung 21 notwendig. Bevorzugt kommt eine chemische Beschichtung mit Nickel in Frage. Dieses Verfahren wird auch "Außen-Stromlose-Beschichtung" genannt. Dieses Verfahren zeichnet sich durch eine sehr präzise Abformung der zu beschichtenden Oberfläche aus. Inhomogenitäten treten bei diesem Verfahren nicht auf. Damit die für die Beschichtung notwendige Reaktion stattfinden kann, ist es erforderlich, eine Bekeimung auf die Oberfläche der aus Kunststoff bestehenden Basisteile 20 aufzubringen. Bevorzugt wird jedoch auch die jeweilige Stützstruktur mitbekeimt und damit auch metallisch beschichtet. Eine solche Bekeimung kann durch einen nasschemischen Prozess aufgebracht werden. Hier wird das entsprechende Bauteil in zwei unterschiedliche Flüssigkeiten nacheinander eingetaucht und dabei bekeimt. Durch eine chemische Umschlagsreaktion werden hierbei Palladium-Keime auf der Oberfläche abgeschieden, auf der anschließend die Nickel-Abscheidungsreaktion stattfinden kann. Alternativ zu dem nasschemischen Bekeimungsvorgang ist auch eine Plasmabeschichtung beziehungsweise ein Sputtern denkbar. Durch die komplexe Geometrie der elektrischen Pfade 10 ist hierbei jedoch darauf zu achten, dass kein Abschattungseffekt auftritt, d.h., dass Bereiche unbeschichtet bleiben. Bei der erwähnten chemisch abgeschiedenen Nickelschicht handelt es sich bevorzugt um eine Nickel-Phosphor-Legierung die die Schicht bildet. Der Phosphorgehalt kann hierbei zwischen 3 bis 14 % gewählt werden, wodurch deutlich Einfluss auf die elektrischen und/oder mechanischen Eigenschaften des Werkstoffes genommen werden kann. Je nach gewünschtem Ergebnis kann der Fachmann den Phosphorgehalt einstellen. Neben dem erwähnten Nickel können auch andere Metalle in einem chemischen Prozess abgeschieden werden, zum Beispiel Kupfer und/oder Gold, wodurch bessere elektrische Eigenschaften im Vergleich zu Nickel erreicht werden. Es ist auch denkbar, dass diese anderen Metalle, insbesondere Kupfer und/oder Gold, in Kombination mit einer Nickelbeschichtung verwendet werden.

Alternativ zur rein chemischen Beschichtung sind auch galvanische (stromgeführte) Prozesse denkbar, um die Metallisierung vorzunehmen. Hierzu ist eine elektrisch leitfähige Grundschicht auf die Kunststoffoberfläche der Basisteile 20 aufzubringen. Für die Aufbringung einer solchen Grundschicht bieten sich wieder chemische Verfahren an. Insofern kommt es zu einer Kombination von zuerst chemischer Beschichtung mit anschließender stromgeführter Abscheidung zur Erzeugung der metallischen Beschichtung 21.

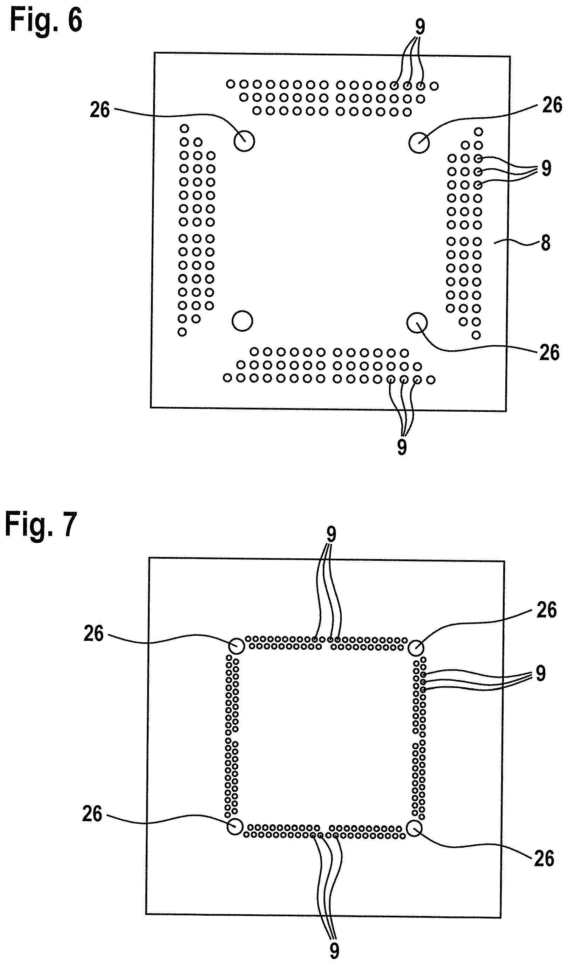

Die Figuren 6 und 7 zeigen Stirnansichten der Wandlerzone 15 nach Entfernen der Grundstruktur 18 und Bereiche der Stützstruktur 25. Deutlich ist erkennbar, dass die in der Figur 6 wiedergegebene grobe Auflösung der Mittenabstände der elektrischen Kontakte 9 am gegenüberliegenden Ende zu einer wesentlich feineren Auflösung führt, so wie dies aus der Figur 7 ersichtlich ist. Ferner sind in den Figuren 6 und 7 die Stützsäulen 26 erkennbar, die konisch ausgebildet sind, sodass ihre Durchmesser in der Figur 7 kleiner als in der Figur 6 erscheinen. Diese Durchmesserverschlankung liegt auch bei den elektrischen Kontakten 9 vor, d.h., die elektrischen Kontakte 9 verschlanken sich mit zunehmender Auflösung, sodass sehr kleine Mittenabstände realisiert werden können. In entsprechender Weise erfolgt die Entflechtung bei der Wandlerzone 16 und nochmals bei der Wandlerzone 17.

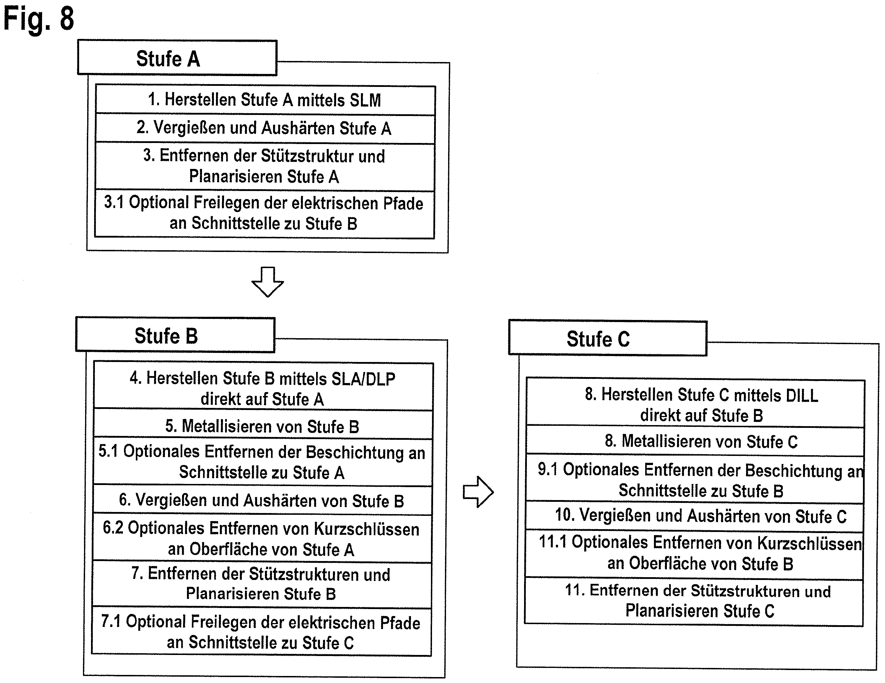

Die Figur 8 verdeutlicht den Herstellungsprozess des Kontaktabstandswandlers 4 in einem Blockdiagramm, das aus den Stufen A, B und C besteht. Die Stufe A entspricht der Herstellung der Wandlerzone 15, die Stufe B der Herstellung der Wandlerzone 16 und die Stufe C der Herstellung der Wandlerzone 17. Die Einzelheiten der verschiedenen Verfahrensschritte sind der Beschriftung der Figur 8 zu entnehmen.

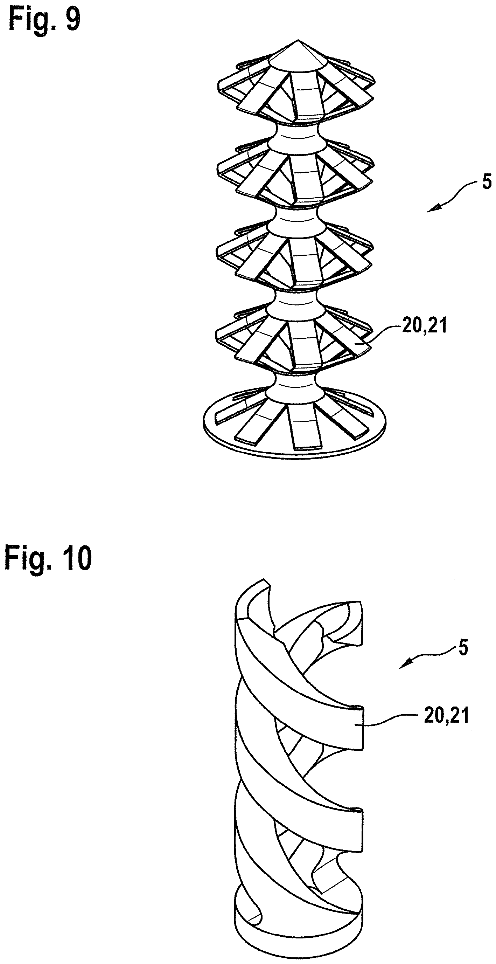

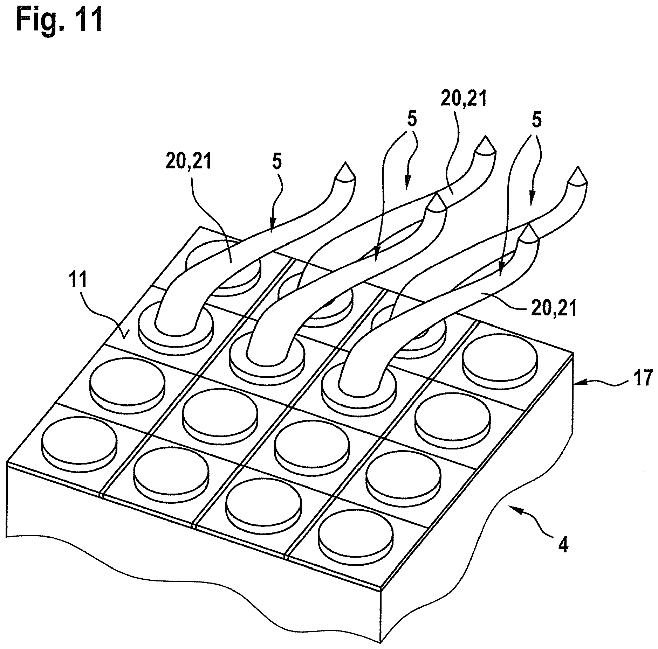

Ist der Kontaktabstandswandler 4 fertiggestellt, so ist es erforderlich, ihn gemäß Figur 1 zu verwenden, d.h., die Seite mit der groben Auflösung ist mit den Kontaktflächen 12 der Leiterplatte 13 zu verbinden und die Seite mit der feinen Auflösung muss in elektrischen Berührungskontakt mit dem Prüfling 2 treten können. Die erstgenannte elektrische Verbindung kann in bekannten, herkömmlichen Techniken erfolgen, beispielsweise mittels federnder elektrischer Zwischenverbinder, Direktverlötung und so weiter. Um dem Prüfling 2 elektrisch zu kontaktieren, werden vorzugsweise die erwähnten Federkontaktstifte 5 verwendet, die vorzugsweise ebenfalls mittels einem additiven Fertigungsverfahren direkt auf den entsprechenden Enden der elektrischen Pfade 10 des Kontaktabstandswandlers 4 erzeugt werden. Dieses Vorgehen kann natürlich auch auf der anderen Seite des Kontaktabstandswandlers 4 vorgenommen werden, sodass es zu einer Berührungskontaktierung zwischen dem Kontaktabstandswandler 4 und den Kontaktflächen 12 der Leiterplatte 13 kommt. Bei diesen Federkontaktstiften 5 handelt es sich beispielsweise um Strukturen, wie sie aus den Figuren 9, 10 und 11 hervorgehen, also um axial federnde Strukturen, die auf einfache Weise einen elektrische Berührungskontakte realisieren. Dabei sind diese Federkontaktstifte 5 mechanisch fest und elektrisch leitfähig an die entsprechenden elektrischen Pfade 10 angeschlossen. Insbesondere handelt es sich bei diesen Strukturen der aus den Figuren 9 bis 11 beispielhaft hervorgehenden Federkontaktstifte 5 um ebenfalls im additiven Fertigungsverfahren hergestellte Basisteile 20 aus Kunststoff, die anschließend mit einer metallischen Beschichtung 21 versehen werden, sodass sie elektrisch leitfähig sind. Auf die Vorgehensweise zur Herstellung kann daher auf die vorstehenden Ausführungen verwiesen werden, die zur Erstellung der elektrischen Kontakte 9 aufgezeigt wurden. Während die Federkontaktstifte 5 der Figuren 9 und 10 axial elastisch einfedern können, handelt es sich bei den Federkontaktstiften 5 der Figur 11 um Bauteile, die über ihre Länge einen S-förmigen Verlauf aufweisen und daher nach den sogenannten Cantilever-Prinzip arbeiten. Sie weisen demzufolge seitlich auskragende Bereiche auf, wodurch federnde Eigenschaften erzielt werden.

Alternativ zu der Federkontaktstiftlösung, so wie sie vorstehend beschrieben wurde und für die Kontaktierung des Prüflings 2 und/oder der Leiterplatte 13 verwendet werden kann, ist es auch möglich, bekannte Techniken einzusetzen, also beispielsweise einen sich an den Kontaktabstandswandler 4 anschließenden Kontaktkopf zu verwenden, der mit Führungsbohrungen versehene Führungsplatten aufweist, in denen längsverschieblich Knicknadeln lagern, die die elektrische Berührungskontaktierung durchführen, oder beispielsweise einen sich an den Kontaktabstandswandler 4 anschließenden Kontaktkopf zu verwenden, der mit Bohrungen versehene Führungsplatten oder dergleichen aufweist, in denen Federkontaktstifte angeordnet sind, wobei diese Federkontaktstifte mit federnbeaufschlagten Kontaktelementen versehen sind, insbesondere Kontaktkolben, die sich in Kontakthülsen längsverschieblich befinden, wobei diese Kontaktelemente/Kontaktkolben die elektrische Berührungskontaktierung durchführen.

Aufgrund des erfindungsgemäßen Vorgehens lassen sich durch die Verwendung der additiven Fertigungsverfahren unterschiedlichste Geometrien mit einer sehr hohen Flexibilität direkt aus einem CAD-Modell herstellen. Hierdurch lassen sich kundenspezifische Bauteile ohne die Notwendigkeit eines Werkzeugs zeitnah realisieren. Besonders bei geringen Stückzahlen, meistens der Stückzahl eins, kann somit sehr wirtschaftlich gearbeitet werden. Durch die Herstellung direkt aus CAD-Daten der additiven Bauteile ergibt sich ein sehr hohes Automatisierungspotential. Durch die erfindungsgemäße Möglichkeit der additiven Verfahren direkt 3D-Geometrien mit einem hohen Freiheitsgrad bezüglich des Designs herstellen zu können, lassen sich sehr kurze elektrische Wege zwischen dem Prüfling 2 und der Leiterplatte 13 realisieren, wodurch sich sehr gute elektrische Eigenschaften ergeben. Hinzu kommt, dass durch die automatisierte Fertigung und die vorstehend genannten Vorteile bei der Herstellung mehrerer identischer Bauteile auch identische elektrische Eigenschaften erzielen lassen, was bei dem zum Stand der Technik genannten verdrahteten Bauformen (Wired-Bauformen) nicht der Fall ist.

## Patentansprüche

1. Verfahren zur Herstellung eines Kontaktabstandswandlers (4) (Spacetransformer), der elektrische Pfade (10) bildende elektrische Kontakte (9) aufweist und bei dem ein erster Kontaktabstand der Kontakte (9) in einen demgegenüber anderen, zweiten Kontaktabstand der elektrischen Kontakte (9) gewandelt wird mit folgenden Schritten:
- Herstellen von jeweils mindestens einem Basisteil (20) von mindestens einigen der elektrischen Kontakte (9), wobei mindestens ein Teil des Basisteils (20) aus Kunststoff hergestellt wird, und
- danach erfolgendem Metallisieren von mindestens dem aus Kunststoff hergestellten Teil des Basisteils (20), **dadurch gekennzeichnet, dass** die Herstellung von dem mindestens einen aus Kunststoff bestehenden Teil des Basisteils (20) mittels additivem Fertigungsverfahren erfolgt.

2. Verfahren nach Anspruch 1, **dadurch gekennzeichnet, dass** als additives Fertigungsverfahren ein Stereolithografie-Verfahren (SLA), ein Digital Light Process Rapid Prototyping-Verfahren (DLP) und/oder ein Dip In Laserlithografie-Verfahren (DILL) eingesetzt wird.

3. Verfahren nach einem der vorhergehenden Ansprüche, **dadurch gekennzeichnet, dass** das Metallisieren in mindestens einem galvanischen und/oder chemischen Prozess erfolgt.

4. Verfahren nach einem der vorhergehenden Ansprüche, **dadurch gekennzeichnet, dass** das gesamte Basisteil (20) aus Kunststoff, bevorzugt mittels des additiven Fertigungsverfahrens, hergestellt, insbesondere als einstückiges Basisteil (20) hergestellt wird.

5. Verfahren nach einem der vorhergehenden Ansprüche, **dadurch gekennzeichnet, dass** das gesamte Basisteil (20) metallisiert wird.

6. Verfahren nach Anspruch 3, **dadurch gekennzeichnet, dass** vor dem galvanischen Metallisieren eine elektrisch leitfähige Startschicht zumindest auf das aus Kunststoff bestehende Teil des Basisteils (20) aufgebracht oder auf der Oberfläche des Teils erzeugt wird.

7. Verfahren nach einem der vorhergehenden Ansprüche, **dadurch gekennzeichnet, dass** vor dem Metallisieren eine Keimschicht zumindest auf das aus Kunststoff bestehende Teil des Basisteils (20) aufgebracht wird, insbesondere im Tauch- oder Plasmaverfahren aufgebracht wird, oder auf der Oberfläche des Teils erzeugt wird.

8. Verfahren nach einem der vorhergehenden Ansprüche, **dadurch gekennzeichnet, dass** nach dem Metallisieren das aus Kunststoff bestehende Teil nicht oder zumindest bereichsweise entfernt wird, insbesondere mittels eines Pyrolyseverfahrens, eines nasschemischen Verfahrens und/oder eines trockenchemischen Verfahrens entfernt wird.

9. Verfahren nach Anspruch 8, **dadurch gekennzeichnet, dass** durch das Metallisieren eine metallische Beschichtung (21) oder aufgrund des zumindest bereichsweise erfolgten Entfernens des aus Kunststoff bestehenden Teils eine Metallhülle erstellt wird.

10. Verfahren nach Anspruch 9, **dadurch gekennzeichnet, dass** in der durch das Metallisieren gebildeten metallischen Beschichtung (21)/Metallhülle mindestens eine Öffnung erzeugt oder belassen wird, die zum Entweichen von Pyrolyseprodukten dient und/oder einen Zugriff von mindestens einem nass- und/oder trockenchemischen Mittel beim Durchführen des nasschemischen und/oder trockenchemischen Verfahrens ermöglicht.

11. Verfahren nach einem der vorhergehenden Ansprüche, **dadurch gekennzeichnet, dass** der Kontaktabstandswandler (4) aus mehreren Wandlerzonen (15,16,17) zusammengesetzt wird, wobei die elektrischen Kontakte (9) jeweils aus mehreren Kontaktzonen (22,23,24) zusammengesetzt werden, jede Kontaktzone (22,23,24) einer Wandlerzone (15,16,17) angehört und jede Kontaktzone (22,23,24) in einer von mehreren, nacheinander durchgeführten Herstellungsstufen erstellt wird, wobei zur Herstellung mindestens einer Kontaktzone (22,23,24) von mindestens einer der Wandlerzonen (15,16,17) das mindestens eine Basisteil (20) erstellt und anschließend metallisiert wird.

12. Verfahren nach Anspruch 11, **dadurch gekennzeichnet, dass** der Kontaktabstand der Kontakte (9) an einem Ende jeder Kontaktzone (22,23,24) gegenüber dem Kontaktabstand der Kontakte (9) an einem anderen Ende dieser jeweiligen Kontaktzone (22,23,24) im Abstandsmaß verändert erstellt ist.

13. Verfahren nach einem der Ansprüche 11 oder 12, jeweils in Kombination mit Anspruch 2, **dadurch gekennzeichnet, dass** bei der Herstellung mindestens einer der Kontaktzonen (22,23,24) mindestens eines der additiven Fertigungsverfahren angewendet wird.

14. Verfahren nach einem der Ansprüche 11 bis 13, **dadurch gekennzeichnet, dass** bei der Herstellung der aus mehreren Kontaktzonen (22,23,24) zusammengesetzten elektrischen Kontakte (9) jede der Kontaktzonen (22,23,24) jedes Kontakts (9) mittels eines anderen der additiven Verfahren hergestellt ist.

15. Verfahren nach einem der Ansprüche 11 bis 14, **dadurch gekennzeichnet, dass** in einem Zwischenverfahrensschritt zumindest eine der Wandlerzonen (15,16,17) mit einer die betreffenden Kontaktzonen (22,23,24) der Kontakte (9) stabilisierenden Stützstruktur (25) hergestellt wird.

16. Verfahren nach Anspruch 15, **dadurch gekennzeichnet, dass** die Stützstruktur (25) mittels additiven Fertigungsverfahren erstellt, insbesondere mit den Kontaktzonen (22,23,24) miterstellt wird.

17. Verfahren nach einem der Ansprüche 15 oder 16, **dadurch gekennzeichnet, dass** die Enden der Kontakte (9) der Kontaktzone (22,23,24) mit der Stützstruktur (25) versehen, insbesondere mittels dieser untereinander verbunden werden.

18. Verfahren nach einem der Ansprüche 11 bis 17, **dadurch gekennzeichnet, dass** zumindest eine der Wandlerzonen (15,16,17) in aushärtender, elektrisch nicht leitender Vergussmasse (28,31,32) eingebettet wird.

19. Verfahren nach Anspruch 18, **dadurch gekennzeichnet, dass** durch Entfernen eines Teils der Vergussmasse (28,31,32) die Enden der Kontaktzonen (22,23,24) der betreffenden Kontakte (9) freigelegt werden, gegebenenfalls nach Entfernen der Stützstruktur (25) oder eines Teils von dieser.

20. Verfahren nach Anspruch 19, **dadurch gekennzeichnet, dass** nach Entfernen des Teils der Vergussmasse (28,31,32) mindestens eine weitere Wandlerzone (15,16,17) auf den Enden der freigelegten Kontaktzonen (22,23,24) erstellt wird.

## Claims

1. A method for producing a contact space transformer (4) which has electrical contacts (9) that form electrical paths (10) and in which a first contact spacing of the contacts (9) is transformed into a comparatively different, second contact spacing of the electrical contacts (9), with the following steps:
- producing at least one respective base part (20) from at least several of the electrical contacts (9), with at least a portion of the base part (20) being made of plastic, and
- subsequent metallization of at least the portion of the base part (20) that is made of plastic, **characterized in that** the production of the at least one portion of the base part (20) that is made of plastic is performed by means of an additive manufacturing process.

2. The method according to claim 1, **characterized in that** a stereolithography process (SLA), a digital light processing rapid prototyping method (DLP), and/or a dip-in laser lithography process (DILL) is used as an additive manufacturing process.

3. The method according to any one of the preceding claims, **characterized in that** the metallization is performed using at least one galvanic and/or chemical process.

4. The method according to any one of the preceding claims, **characterized in that** the entire base part (20) is made of plastic, preferably by means of the additive manufacturing process, particularly as a one-piece base part (20).

5. The method according to any one of the preceding claims, **characterized in that** the entire base part (20) is metallized.

6. The method according to claim 3, **characterized in that,** before the galvanic metallization, an electrically conductive starting layer is applied to at least the portion of the base part (20) that is made of plastic or produced on the surface of the portion.

7. The method according to any one of the preceding claims, **characterized in that**, before metallization, a seed layer is applied to at least the portion of the base part (20) that is made of plastic, particularly by means of a dipping or plasma process, or produced on the surface of the portion.

8. The method according to any one of the preceding claims, **characterized in that**, after metallization, the portion made of plastic is not removed or removed at least in areas, particularly by means of a pyrolysis process, a wet chemical process, and/or a dry chemical process.

9. The method according to claim 8, **characterized in that**, as a result of metallization, a metallic coating (21) or - as a result of the removal of the portion that is made of plastic at least in areas - a metal shell is produced.

10. The method according to claim 9, **characterized in that** at least one opening is produced or left in the metallic coating (21)/metal shell formed through metallization that has the purpose of allowing pyrolysis products to escape and/or enables access by at least one wet and/or dry chemical agent during the execution of the wet chemical and/or dry chemical process.

11. The method as set forth in any one of the preceding claims, **characterized in that** the contact space transformer (4) is composed of several transformer zones (15, 16, 17), with the electrical contacts (9) each being composed of several contact zones (22, 23, 24), each contact zone (22, 23, 24) belonging to a transformer zone (15, 16, 17), and each contact zone (22, 23, 24) being produced in one of several successively executed manufacturing stages, with the at least one base part (20) being produced and subsequently metallized in order to produce at least one contact zone (22, 23, 24) of at least one of the transformer zones (15, 16, 17).

12. The method according to claim 11, **characterized in that** the contact spacing of the contacts (9) at one end of each contact zone (22, 23, 24) is created so as to have a different spacing interval than the contact spacing of the contacts (9) at another end of this contact zone (22, 23, 24).

13. The method according to claim 11 or 12, in combination with claim 2 in each case, **characterized in that** at least one of the additive manufacturing processes is applied during manufacturing of at least one of the contact zones (22, 23, 24).

14. The method according to any one of claims 11 to 13, **characterized in that**, during the production of the electrical contacts (9) that are composed of several contact zones (22, 23, 24), each of the contact zones (22, 23, 24) of each contact (9) is produced by means of another of the additive processes.

15. The method according to any one of claims 11 to 14, **characterized in that**, in an intermediate method step, at least one of the transformer zones (15, 16, 17) is produced with a supporting structure (25) that stabilizes the respective contact zones (22, 23, 24) of the contacts (9).

16. The method according to claim 15, **characterized in that** the supporting structure (25) is created by means of additive manufacturing processes, particularly together with the contact zones (22, 23, 24).

17. The method according to claim 15 or 16, **characterized in that** the ends of the contacts (9) of the contact zone (22, 23, 24) are provided with the supporting structure (25), particularly interconnected by means of same.

18. The method according to any one of claims 11 to 17, **characterized in that** at least one of the transformer zones (15, 16, 17) is embedded in curing, electrically nonconductive casting compound (28, 31, 32).

19. The method according to claim 18, **characterized in that,** through the removal of a portion of the casting compound (28, 31, 32), the ends of the contact zones (22, 23, 24) of the respective contacts (9) are laid bare, if applicable after removal of the supporting structure (25) or a portion thereof.

20. The method according to claim 19, **characterized in that,** after removal of the portion of the casting compound (28, 31, 32), at least one additional transformer zone (15, 16, 17) is created on the ends of the laid bare contact zones (22, 23, 24).

## Revendications

1. Procédé de fabrication d'un transformateur d'écartement des contacts (4) qui présente des contacts électriques (9) formant des pistes électriques (10) et lors duquel un premier écartement des contacts (9) est transformé en un second écartement des contacts électriques (9) autre par rapport à celui-ci, avec les étapes suivantes :
- fabrication à chaque fois d'au moins une partie de base (20) d'au moins quelques-uns des contacts électriques (9), dans lequel au moins une partie de la partie de base (20) est fabriquée en plastique, et
- métallisation s'effectuant ensuite d'au moins la partie fabriquée en plastique de la partie de base (20), **caractérisé en ce que** la fabrication de l'au moins une partie constituée de plastique de la partie de base (20) s'effectue au moyen d'un procédé de fabrication additif.

2. Procédé selon la revendication 1, **caractérisé en ce qu'**un procédé de stéréolithographie (SLA), un procédé de prototypage rapide digital light process (DLP) et/ou un procédé de lithographie par laser dip-in (DILL) est utilisé en tant que procédé de fabrication additif

3. Procédé selon une des revendications précédentes, **caractérisé en ce que** la métallisation s'effectue dans au moins un processus galvanique et/ou chimique.

4. Procédé selon une des revendications précédentes, **caractérisé en ce que** la partie de base entière (20) est fabriquée en plastique, de préférence au moyen du procédé de fabrication additif, notamment fabriquée en tant que partie de base d'une pièce (20).

5. Procédé selon une des revendications précédentes, **caractérisé en ce que** la partie de base entière (20) est métallisée.

6. Procédé selon la revendication 3, **caractérisé en ce qu'**une couche de départ électriquement conductrice est appliquée au moins sur la partie constituée de plastique de la partie de base (20) ou générée sur la surface de la partie avant la métallisation galvanique.

7. Procédé selon une des revendications précédentes, **caractérisé en ce qu'**une couche germinale est appliquée au moins sur la partie constituée de plastique de la partie de base (20), notamment dans le procédé d'immersion ou plasma, ou générée sur la surface de la partie avant la métallisation.

8. Procédé selon une des revendications précédentes, **caractérisé en ce que** la partie constituée de plastique n'est pas éliminée ou au moins par régions après la métallisation, est notamment éliminée au moyen d'un procédé de pyrolyse, d'un procédé de chimie humide et/ou d'un procédé de chimie sèche.

9. Procédé selon la revendication 8, **caractérisé en ce qu'**un enrobage métallique (21) ou une enveloppe métallique en raison de l'élimination effectuée au moins par régions de la partie constituée de plastique est cré(é)e par la métallisation.

10. Procédé selon la revendication 9, **caractérisé en ce qu'**au moins une ouverture est générée ou laissée dans l'enrobage métallique (21)/l'enveloppe métallique formé(e) par la métallisation, laquelle sert au dégagement de produits de pyrolyse et/ou permet un accès d'au moins un agent de chimie humide et/ou sèche lors de la réalisation du procédé de chimie humide et/ou chimie sèche.

11. Procédé selon une des revendications précédentes, **caractérisé en ce que** le transformateur d'écartement des contacts (4) est composé de plusieurs zones de transformateur (15, 16, 17), dans lequel les contacts électriques (9) sont chacun composés de plusieurs zones de contact (22, 23, 24), chaque zone de contact (22, 23, 24) appartient à une zone de transformateur (15, 16, 17) et chaque zone de contact (22, 23, 24) est créée dans une étape de plusieurs étapes de fabrication réalisées successivement, dans lequel l'au moins une partie de base (20) est créée, puis métallisée pour la fabrication d'au moins une zone de contact (22, 23, 24) d'au moins une des zones de transformateur (15, 16, 17).

12. Procédé selon la revendication 11, **caractérisé en ce que** l'écartement des contacts (9) est créé de manière modifiée dans la mesure d'écartement à une extrémité de chaque zone de contact (22, 23, 24) par rapport à l'écartement des contacts (9) à une autre extrémité de cette zone de contact respective (22, 23, 24).

13. Procédé selon une des revendications 11 ou 12, à chaque fois en combinaison avec la revendication 2, **caractérisé en ce qu'**au moins un des procédés de fabrication additifs est appliqué lors de la fabrication d'au moins une des zones de contact (22, 23, 24).

14. Procédé selon une des revendications 11 à 13, **caractérisé en ce que** chacune des zones de contacts (22, 23, 24) de chaque contact (9) est fabriquée au moyen d'un autre des procédés additifs lors de la fabrication des contacts électriques (9) composés de plusieurs zones de contact (22, 23, 24).

15. Procédé selon une des revendications 11 à 14, **caractérisé en ce qu'**au moins une des zones de transformateur (15, 16, 17) est fabriquée avec une structure d'appui (25) stabilisant les zones de contact concernées (22, 23, 24) des contacts (9) dans une étape de procédé intermédiaire.

16. Procédé selon la revendication 15, **caractérisé en ce que** la structure d'appui (25) est créée au moyen de procédés de fabrication additifs, notamment créée avec les zones de contact (22, 23, 24).

17. Procédé selon une des revendications 15 ou 16, **caractérisé en ce que** les extrémités des contacts (9) de la zone de contact (22, 23, 24) sont pourvues de la structure d'appui (25), notamment connectées entre elles au moyen de celle-ci.

18. Procédé selon une des revendications 11 à 17, **caractérisé en ce qu'**au moins une des zones de transformateur (15, 16, 17) est encastrée dans une masse de scellement durcissante, électriquement non conductrice (28, 31, 32).

19. Procédé selon la revendication 18, **caractérisé en ce que** les extrémités des zones de contact (22, 23, 24) des contacts concernés (9) sont enlevées par élimination d'une partie de la masse de scellement (28, 31, 32), éventuellement après élimination de la structure d'appui (25) ou d'une partie de celle-ci.

20. Procédé selon la revendication 19, **caractérisé en ce qu'**au moins une autre zone de transformateur (15, 16, 17) est créée sur les extrémités des zones de contact enlevées (22, 23, 24) après élimination de la partie de la masse de scellement (28, 31, 32).
